# EUROPEAN PATENT APPLICATION

(11) **EP 1 923 918 A2**
(43) Date of publication of application: **21.05.2008**
(21) Application number: 07120384.8
(22) Date of filing: 09.11.2007
(51) Int. Cl.: H01L 31/0352, H01L 31/065, H01L 31/072

(54) **Graded hybrid amorphous silicon nanowire solar cells**

(30) Priority: 15.11.2006 US 599722
(71) Applicant: General Electric Company, Schenectady, NY 12345 (US)
(72) Inventor: Tsakalakos, Loucas, Niskayuna, NY 12309 (US); Johnson, James Neil, Scotia, NY 12302 (US); Manivannan, Venkatesan, Fort Colllins, CO 80526 (US)
(74) Representative: Szary, Anne Catherine

(57) **Abstract**

The present invention is directed to compositionally-graded hybrid nanostructure-based photovoltaic devices comprising elongated semiconductor nanostructures and an amorphous semiconductor single layer with continuous gradation of doping concentration across its thickness from substantially intrinsic to substantially conductive. In other embodiments, the present invention is directed to methods of making such photovoltaic devices, as well as to applications which utilize such devices (e.g., solar cell modules).

## Description

### TECHNICAL FIELD

The present invention relates generally to photovoltaic devices, and specifically to such photovoltaic devices comprising elongated silicon nanostructures as active elements within the device.

### BACKGROUND INFORMATION

Presently, silicon (Si) is the most commonly used material in the fabrication of solar cells, such solar cells being used for converting sunlight into electricity. Single and multi-junction p-n solar cells are used for this purpose, but none are efficient enough to significantly reduce the costs involved in the production and use of this technology. Consequently, competition from conventional sources of electricity precludes the widespread use of such solar cell technology.

The primary loss process in existing solar cells occurs when a photo-excited electron quickly loses any energy it may have in excess of the bandgap due to interactions with lattice vibrations, known as phonons, resulting in increased recombination. This loss alone limits the conversion efficiency of a standard cell to about 44%. Additionally, recombination of photo-generated electrons and holes with trap states in the semiconductor crystal associated with point defects (interstitial impurities), metal clusters, line defects (dislocations), planar defects (stacking faults), and/or grain boundaries reduces the efficiency further. Although this latter reduction in efficiency can be overcome by using other materials with appropriate properties, particularly long diffusion lengths of the photo-generated carriers, this still does not bring this technology to a cost parity with more conventional sources of electricity. Further loss is incurred owing to the fact that semiconductors will not absorb light with energy lower than the bandgap of the material used. With all of the photovoltaic losses taken into account, Shockley and Queisser were able to show that the performance of a single junction cell was limited to just over 30 percent efficiency for an optimal cell with a bandgap of 1.3 electron volts (eV) (Shockley and Queisser, "Detailed Balance Limit of Efficiency of p-n Junction Solar Cells," J. Appl. Phys., 1961, 32(3), pp. 510-519). More recent calculations have shown this "limit efficiency" for a single junction to be 29 percent (Kerr et al., "Lifetime and efficiency of limits of crystalline silicon solar cells," Proc. 29th IEEE Photovoltaic Specialists Conference, 2002, pp. 438-441).

Nanostructures

Silicon nanowires have been described in p-n junction diode arrays (Peng et al., "Fabrication of large-Area Silicon Nanowire p-n Junction Diode Arrays," Adv. Mater., 2004, vol. 16, pp. 73-76). Such arrays, however, were not configured for use in photovoltaic devices, nor was it suggested how such arrays might serve to increase the efficiency of solar cells.

Silicon nanostructures have been described in solar cell devices (Ji et al., "Silicon Nanostructures by Metal Induced Growth (MIG) for Solar Cell Emitters," Proc. IEEE, 2002, pp. 1314-1317). In such devices, Si nanowires can be formed, embedded in microcrystalline Si thin films, by sputtering Si onto a nickel (Ni) pre-layer, the thickness of which determines whether the Si nanowires grow inside the film or not. However, such nanowires are not active photovoltaic (PV) elements; they merely serve in an anti-reflective capacity.

Solar cells comprising silicon nanostructures, where the nanostuctures are active PV elements, have been described in commonly-assigned co-pending United States Patent Application Serial No. 11/081,967, filed March 16, 2005. In that particular Application, the charge separating junctions are largely contained within the nanostructures themselves, generally requiring doping changes during the synthesis of such nanostructures.

### Surface and Interface Defects

Defect states due to structural imperfections or impurity atoms can reside on the surface and within the bulk of monocrystalline semiconductors. In addition, polycrystalline semiconductor materials are comprised of randomly-oriented crystal grains with grain boundaries, the grain boundaries inducing a large number of bulk and surface defect states. Because charge carriers can recombine at defect sites and are therefore lost as current carriers, defects typically adversely affect the operation or performance of electronic and/or optoelectronic devices such as solar cells. Accordingly, the surfaces of monocrystalline or polycrystalline semiconductor substrates are often passivated during device fabrication in order to minimize the negative effects of surface defects. One method for surface passivation is by forming a layer of intrinsic (undoped) amorphous semiconductor material on the monocrystalline or polycrystalline semiconductor substrate. This decreases the recombination of charge carriers at the substrate surface and improves the performance of the device.

Most electronic and/or optoelectronic devices require the formation of a junction. For example, a material of one conductivity type is placed in contact with a material of the opposite conductivity type to form a heterojunction. Abrupt band bending at the heterojunction due to a change in conductivity type and/or variations in band gap leads to a high density of interface states that result in charge carrier recombination. In addition, interruptions between processing steps during device fabrication allow impurity atoms and/or spurious contaminants to be trapped in the interfaces of a multilayer structure. These defects can act as sites for charge carrier recombination that degrade device performance. Accordingly, a device design that eliminates the interfaces between distinct layers would be quite useful.

In 1993, Sanyo Electric Co. began development on an approach to photovoltaic device fabrication that incorporates a plasma-deposited intrinsic a-Si:H layer to provide the required passivation of the substrate surface. A separately-doped a-Si:H layer is deposited on top of the intrinsic layer to form the heterojunction. This structure is termed "HIT" for Heterojunction with Intrinsic Thin-layer. The intrinsic layer thickness is less than 250 Å, with an optimum thickness in the 40-50 Å range. See United States Patent Nos. 5,213,628 and 5,648,675, as well as United States Patent Publication No. 20020069911 A1.

An experimental study (K.S. Lim, et al., A novel structure, high conversion efficiency p-SiC/graded p-SiC/i-Si/n-Si/ metal substrate-type amorphous silicon solar cell, J. Appl. Phys. 56(2), 15 Jul. 1984) on the effects of a graded composition p-type a-SiC:H layer placed between p- and i-layers of an a-Si/metal substrate p-i-n thin film solar cell has been carried out. Results indicated enhanced V_{oc} and I_{sc} values over conventional a-Si/metal substrate p-i-n devices, including a marked increased in collection efficiency at shorter wavelengths. The observed improvement in the blue response is attributed to a reduction in interface recombination. Additionally, computational analysis on the effects of a graded band-gap layer placed between the p- and i-layers of an a-Si:H based p-i-n thin film solar cell (P. Chatterjee, A computer analysis of the effect of a wide-band-gap emitter layer on the performance of a-Si:H-based heterojunction solar cells, J. Appl. Phys. 79(9), 1 May 1996) indicates that use of a graded band-gap layer should provide a reduction in the number of interface states, and can enhance conversion efficiency in these devices by more than 25%.

A p-i-n thin film solar cell having an i-type semiconductor absorber layer formed of a variable bandgap material, said i-layer being positioned between a p-type semiconductor layer and an n-type semiconductor layer has been described. See United States Patent No. 5,252,142. A variable bandgap i-layer absorber provides for improved photoelectric conversion efficiency.

Recently, a composite article comprising a substrate surface and a graded-composition coating disposed on a substrate surface has been described. See United States Patent Application Publication No. 20040046497 A1. The composition of the coating material varies substantially continuously across its thickness to reduce transmission rates of oxygen, water vapor, and other chemical species through the substrate to provide a diffusion barrier to protect chemically sensitive devices or materials.

As a result of the foregoing, any modifications of such PV technology, particularly modifications incorporating nanoscale materials, that lead to facilitated fabrication and efficiencies on par with the more traditional sources of electricity, would be entirely beneficial-particularly where such modifications reduce surface and interface defects.

### BRIEF DESCRIPTION OF THE INVENTION

Embodiments of the present invention are generally directed to compositionally-graded hybrid photovoltaic nanostructure-based devices, methods of making such devices, and to systems and applications incorporating such devices.

In some embodiments, such above-mentioned nanostructure-based devices are comprised of a semiconductor nanowire (or other suitable elongated nanostructure) film of one conductivity type on a semiconductor, metal, or glass substrate; and an amorphous semiconductor layer that is compositionally graded across its thickness from substantially intrinsic at the interface with the substrate/nanowire film to substantially conductive at the opposite side. A heterojunction is formed when the amorphous semiconductor layer is compositionally graded to the opposite conductivity type as that of the substrate/nanowire film.

In some embodiments, the present invention is directed to a photovoltaic device comprising: (a) a plurality of elongated semiconducting nanostructures (of which nanowires are a species) disposed on a substrate, the elongated semiconducting nanostructures having a doping of a first type; and (b) a single amorphous layer of semiconducting material disposed conformally on the elongated semiconducting nanostructures and having an interface between the amorphous layer and the elongated semiconducting nanostructures, wherein the amorphous layer is compositionally graded from substantially intrinsic at the interface to substantially conducting on the amorphous layer's opposing side, and wherein the graded composition of the amorphous layer is provided by a doping of a second type. Generally, such a compositionally graded amorphous layer provides a band gap with a continuous variation of localized states. In some such embodiments, a layer of transparent conductive material (TCM) is deposited on the amorphous layer. Furthermore, top and bottom contacts are typically provided which are operable for connecting the device to an external circuit, wherein the bottom electrode is typically (but not always) integrated with the substrate.

Typically, such above-described compositional grading is achieved by adjusting the doping levels during fabrication of the amorphous semiconductor layer. The graded amorphous layers are disposed on the semiconductor nanostructure/substrate surfaces in a conformal fashion, wherein a single compositionally graded layer is employed (in contrast to prior art methods which use a combination of distinct, individual layers to form the hybrid device, none of which are on a nanowire (or other nanostructure variant) film active layer).

In some embodiments, the present invention is directed to a method comprising the steps of: (a) providing a plurality of elongated semiconducting nanostructures on a substrate, the elongated semiconducting nanostructures having a doping of a first type; and (b) conformally-depositing an amorphous layer of semiconducting material on the elongated semicondcuting nanostructures such that they form an interface, wherein the amorphous layer is compositionally graded from substantially intrinsic at the interface to substantially conducting on the amorphous layer's opposing side, and wherein the graded composition of the amorphous layer is provided by a doping of a second type.

In some embodiments, the present invention is directed to assemblies of photovoltaic devices or solar cells (in the form of modules or solar panels), and to the use of such assemblies on building roofs, wherein such assemblies can be connected through an inverter to the electricity grid.

The foregoing has outlined rather broadly the features of the present invention in order that the detailed description of the invention that follows may be better understood. Additional features and advantages of the invention will be described hereinafter which form the subject of the claims of the invention.

### BRIEF DESCRIPTION OF THE DRAWINGS

For a more complete understanding of the present invention, and the advantages thereof, reference is now made to the following descriptions taken in conjunction with the accompanying drawings by way of example, in which:
FIGURE 1 depicts compositionally-graded hybrid photovoltaic (PV) nanowire-based cell comprising silicon (Si) nanowires (or other semiconducting elongated nanostructures), in accordance with some embodiments of the present invention;
FIGURE 2 depicts how the conformal layer is compositionally graded, in accordance with some embodiments of the present invention;
FIGURE 3 depicts variations on substrate 102, wherein the substrate comprises layered regions, in accordance with some embodiments of the present invention;
FIGURE 4 depicts a variation on the conformal coating depicted in FIGURE 1, in accordance with some or other embodiments of the present invention; and

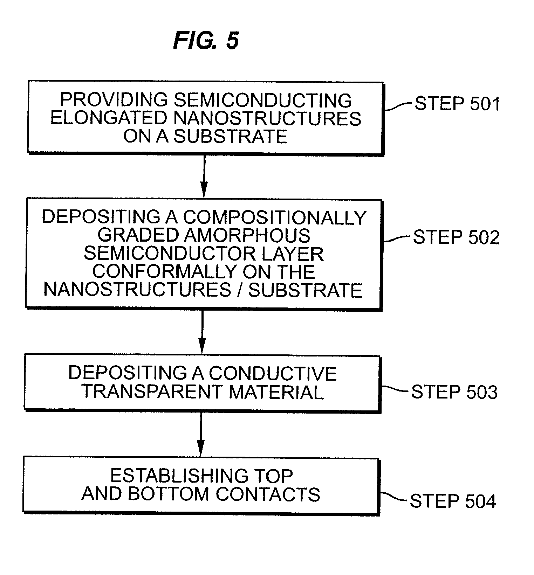

FIGURE 5 outlines, in stepwise fashion, a method for forming a photovoltaic device comprising elongated nanostructures and a compositionally graded amorphous layer, in accordance with some embodiments of the present invention.

### DETAILED DESCRIPTION OF THE INVENTION

In some embodiments, the present invention is directed to photovoltaic (PV) devices comprising silicon (Si) nanowires (or elongated nanostructures of other semiconducting material) and a compositionally-graded amorphous layer conformally disposed on the nanowires. Generally, the amorphous layer is of the same or similar bulk composition as the nanowires, but while the nanowires are uniformly doped, the amorphous layer has a doping (of opposite type so as to establish a charge-separating junction) that varies (in terms of amount) across the layer, from substantially intrinsic at the nanowire/amorphous layer interface to substantially conducting on the opposite side of the layer.

In the following description, specific details are set forth such as specific quantities, sizes, etc. so as to provide a thorough understanding of embodiments of the present invention. However, it will be obvious to those skilled in the art that the present invention may be practiced without such specific details. In many cases, details concerning such considerations and the like have been omitted inasmuch as such details are not necessary to obtain a complete understanding of the present invention and are within the skills of persons of ordinary skill in the relevant art.

Referring to the drawings in general, it will be understood that the illustrations are for the purpose of describing a particular embodiment of the invention and are not intended to limit the invention thereto.

While most of the terms used herein will be recognizable to those of skill in the art, the following definitions are nevertheless put forth to aid in the understanding of the present invention. It should be understood, however, that when not explicitly defined, terms should be interpreted as adopting a meaning presently accepted by those of skill in the art.

A "photovoltaic device," as defined herein, is a device comprising at least one photodiode and which utilizes the photovoltaic effect to produce an electromotive force (e.m.f.). See Penguin Dictionary of Electronics, Third Edition, V. Illingworth, Ed., Penguin Books, London, 1998. An exemplary such device is a "solar cell," wherein a solar cell is a photodiode whose spectral response has been optimized for daytime radiation from the sun.

"Nanoscale," as defined herein, generally refers to dimensions below 1 µm.

"Nanostructures," as defined herein, generally refer to structures that are nanoscale in at least two dimensions.

"Elongated nanostructures," as defined herein, are nanostructures that are nanoscale in at least two dimensions. Exemplary such elongated nanostructures include, but are not limited to, nanowires, nanorods, nanotubes, and the like.

"Nanowires," as defined herein, are generally elongated nanostructures typically being sub-micron (< 1 µm) in at least two dimensions and having a largely cylindrical shape.

"Conformal," as defined herein, pertains to coatings that largely adopt (i.e., conform to) the shape of the structures which they coat. This term should be interpreted broadly, however, permitting the substantial filling of void space between the coated structures-at least in some embodiments.

"Semiconducting material," as defined herein, is material that has a conductivity that is generally intermediate between metals and insulators, and wherein such a material has an energy gap, or "bandgap," between its valence and conduction bands. In its pure, undoped state, such semiconducting material is typically referred to as being "intrinsic."

"p-doping," as defined herein, refers to doping of semiconducting material with impurities that introduce holes effective for increasing the conductivity of the intrinsic semiconducting material and moving the Fermi level towards the valence band such that a junction can be formed.. An exemplary such p-doping is the addition of small quantities of boron (B) to silicon (Si).

"n-doping," as defined herein, refers to doping of semiconducting material with impurities that introduce electrons effective for increasing the conductivity of the intrinsic semiconducting material and moving the Fermi level towards the conduction band such that a junction can be formed.. An exemplary such n-doping is the addition of small quantities of phosphorous (P) to silicon (Si).

A "charge separating junction," as defined herein, comprises a boundary between materials of different type (e.g., differing dopants and/or bulk composition) that allows for the separation of electrons and holes.

A "heterojunction," as defined herein and pertaining to photovoltaic devices, is a charge separating junction established via the contact of two differing semiconductor materials having differing bandgaps.

"Active PV elements," as defined herein, are those elements of a PV device responsible for establishing a charge-separating junction.

A "p-n photovoltaic device," as defined herein, is a device comprising at least one photodiode comprising a charge-separating junction established via the contact of a p-doped semiconductor and an n-doped semiconductor.

A "p-i-n photovoltaic device," as defined herein, is a stack of three materials with one layer being doped p-type (primarily hole conduction), one being undoped (i.e., intrinsic), and the other being doped n-type (primarily electron conduction).

"Compositionally-graded," as defined herein and relating to the conformal amorphous layer of the PV devices described herein, means that the bulk semiconductor material comprises a dopant concentration that varies across the thickness of the layer such that it is substantially intrinsic at the interface with the elongated nanostructures (having a doping of a first type, e.g., p-doping) and progressively more heavily doped (with a dopant of a second type, e.g., n-doping) across the thickness of the layer such that on the opposite side it has a doping level that is sufficient to establish a charge separating junction in the PV device within which it resides. "Compositionally-graded hybrid," as defined herein and relating to the PV devices described herein, means that a compositionally-graded amorphous layer occurs in conjunction with the underlying silicon nanostructures or nanowires.

"Solar cells," as defined herein, is essentially a photovoltaic device that is optimized for energy conversion from solar radiation.

"Nanotemplates," as defined herein, are inorganic or organic films comprising an array of pores or columns having nanoscale dimensions.

### Devices

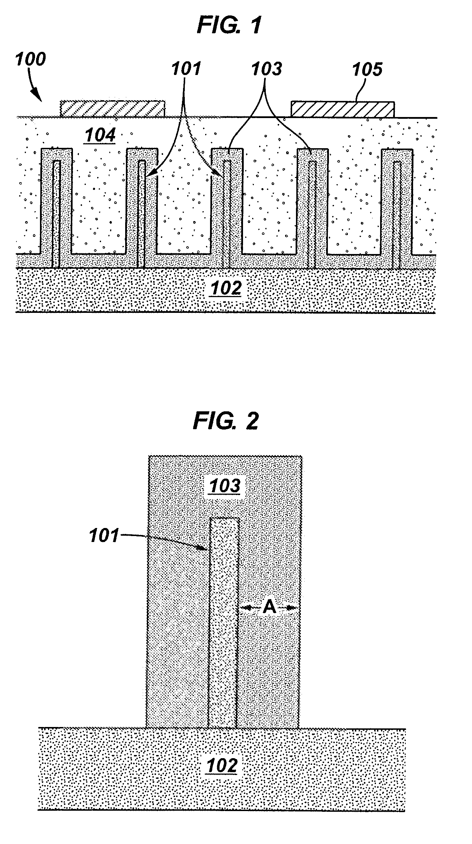

Referring to FIGURE 1, in some embodiments, the present invention is directed to a compositionally-graded hybrid nanostructure-based photovoltaic device comprising: (a) a plurality of elongated semiconducting nanostructures 101 disposed on a substrate 102, the elongated semiconducting nanostructures having a doping of a first type; and (b) an amorphous layer 103 of semiconducting material disposed conformally on the elongated semiconducting nanostructures and having an interface between the amorphous layer and the elongated semiconducting nanostructures, wherein the amorphous layer is compositionally graded from substantially intrinsic at the interface to substantially conducting on the amorphous layer's opposing side, and wherein the graded composition of the amorphous layer is provided by a doping of a second type.

In such embodiments, the compositionally graded amorphous layer provides a band gap with a continuous variation of localized states, and a heterojunction is formed when the amorphous semiconductor layer is compositionally-graded to the opposite conductivity type as that of the semiconducting nanowires. In some such embodiments, a layer of transparent conductive material (TCM) 104 is deposited on the amorphous layer 103. Furthermore, top 105 and bottom contacts are typically provided operable for connecting the device to an external circuit, wherein the bottom electrode is typically (but not always) integrated with the substrate (vide infra).

The elongated semiconducting nanostructures 101 can be comprised of any material which suitably provides for a PV device in accordance with embodiments of the present invention. Suitable materials include, but are not limited to, silicon (Si), SiGe, gallium arsenide (GaAs), gallium phosphide (GaP), indium phosphide (InP), GaInP, germanium (Ge), GaInAs, aluminum gallium arsenide (AIGaAs), zinc oxide (ZnO), gallium nitride (GaN), aluminum nitride (A1N), indium nitride (InN), boron nitride (BN), selenium (Se), cadmium selenide (CdSe), cadmium telluride (CdTe), Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and similar compositions, and combinations thereof.

The nanostructures 101 typically comprise a length in the range of from about 100 nm to about 100 µm, and a width in the range of from about 5 nm to about 1 µm. In some embodiments, the nanostructures are arranged on the substrate in a substantially vertical orientation, i.e., in relation to the plane of the substrate, a majority of said nanostructures form an angle of greater than 45°. In other embodiments, the nanostructures are disposed on the substrate in a largely random manner.

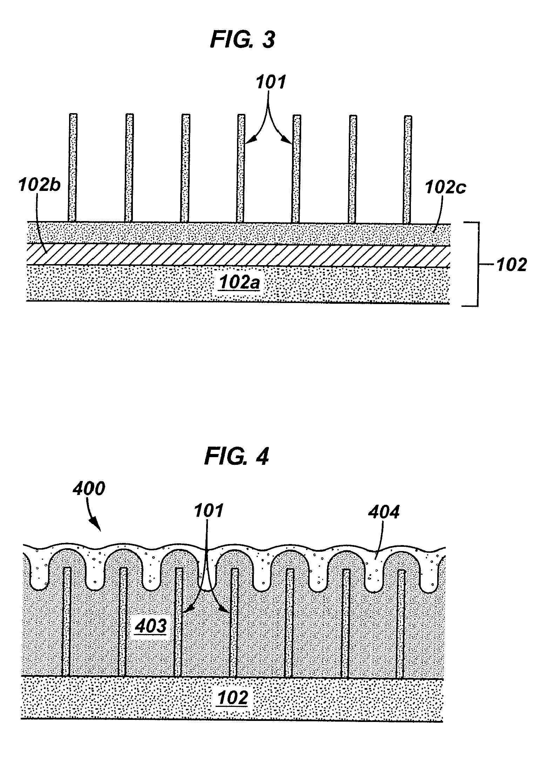

In some embodiments, the above devices further comprise a nanoporous template residing on, or integral with, the substrate, from which the elongated semiconducting nanostructures emanate. This is often the case when such nanostructures are grown in the template. Referring to FIGURE 3, in some embodiments, layered substrate 102 can comprise a nanoporous template 102c and/or a conductive layer 102b residing on a substrate support 102a.

In some embodiments, the porous nanotemplate 102c comprises a material selected from the group consisting of anodized aluminum oxide (AAO), silicon dioxide (SiO₂), boron nitride (BN), silicon nitride (Si₃N₄), and the like. In some embodiments, the porous nanotemplate 102c comprises a thickness (or an average thickness) of between about 0.1 µm and about 100 µm, wherein the porous nanotemplate comprises a pore diameter (or an average diameter) of between about 1 nm and about 1 µm, and wherein the porous nanotemplate comprises a pore density between about 10⁵ per cm² and about 10¹¹ per cm².

In some such device embodiments, the elongated semiconducting nanostructures are p-doped, although they could also be n-doped. To generate a charge separating junction within the device, however, the doping of the nanostructures should be opposite that of the graded doping of the amorphous layer.

In some such device embodiments, the amorphous layer 103 comprises a semiconducting material selected from the group consisting of silicon, GaAs, GaP,

InP, GaInP, Ge, SiGe, GaInAs, AlGaAs, ZnO, GaN, AIN, InN, BN, Se, CdSe, CdTe, CdS, Cd-O-Te, Cd-Mn-O-Te, ZnTe, Zn-O-Te, Zn-Mn-O-Te, MnTe, Mn-O-Te, oxides of copper, carbon, titanium oxide, Cu-In-Ga-Se, Cu-In-Se, and similar such compositions, and combinations thereof. Typically, the amorphous layer comprises a relative thickness in the range of 20 Å to 200 Å

As mentioned above, and as depicted in FIGURE 2, the amorphous layer 103 is compositionally-graded (in terms of dopant concentration) across its thickness A, wherein the dopant concentration typically increases from almost zero near the nanostructures 101 and surface 102 to an amount sufficient to establish a charge separating junction at opposite side of the layer. Typically, such doping is n-doping comprising n-dopants (e.g., N, P, As, etc.), but such doping could alternatively be p-doping in the situation where the nanostructures 101 where n-doped.

In device embodiments employing a layer of transparent conductive material, the transparent conductive material can be a transparent conductive oxide (TCO). In some such embodiments, the transparent conductive oxide is indium-tin-oxide (ITO).

In some other such embodiments, the transparent conductive oxide is doped ZnO. Typically, the transparent conductive material comprises a thickness between about 0.05 µm and about 1 µm.

In some embodiments, the substrate provides a bottom contact. In some or other embodiments, the layer of transparent conductive material provides a top contact. Depending on the intended use, the device can be configured for either top and/or bottom illumination.

### Device Fabrication

In some embodiments, the present invention is directed to methods for making the above-described compositionally-graded hybrid nanostructure-based photovoltaic devices, such methods comprising the steps of: (Step 501) providing a plurality of elongated semiconducting nanostructures on a substrate, the elongated semiconducting nanostructures having a doping of a first type; (Step 502) conformally-depositing an amorphous layer of semiconducting material on the elongated semicondcuting nanostructures such that they form an interface, wherein the amorphous layer is compositionally graded from substantially intrinsic at the interface to substantially conducting on the amorphous layer's opposing side, and wherein the graded composition of the amorphous layer is provided by a doping of a second type; (Step 503) depositing a conductive transparent material as a layer on the amorphous layer; and (Step 504) establishing top and bottom contacts operable for connecting the device to an external circuit.

In some such above-described method embodiments, the elongated nanostructures are provided by growing them via a method selected from the group consisting of chemical vapor deposition (CVD), metal-organic chemical vapor deposition (MOCVD), plasma-enhanced chemical vapor deposition (PECVD), hot wire chemical vapor deposition (HWCVD), atomic layer deposition, electrochemical deposition, solution chemical deposition, and combinations thereof. In some such embodiments, the elongated nanostructures are provided by catalytically growing them from metal nanoparticles, where the metal nanoparticles may reside in a nanoporous template, and wherein the metal nanoparticles may comprise a metal selected from the group consisting of gold (Au), indium (In), gallium (Ga), and iron (Fe).

In some embodiments, a nanoporous template is employed to grow elongated nanostructures such as is described in commonly-assigned United States Patent Application Serial No. 11/141,613, filed 27th May, 2005.

In some such above-described method embodiments, the step of conformally-depositing the amorphous layer is carried out using a technique selected from the group consisting of CVD, MOCVD, PECVD, HWCVD, sputtering, and combinations thereof. In some such embodiments, the amorphous layer is compositionally graded by doping with a dopant precursor that decomposes to a dopant species upon being deposited, and wherein the doping is provided in a graded manner during deposition by progressively increasing the dopant precursor concentration as the amorphous layer is deposited. Suitable dopant precursors include, but are not limited to, B₂H₆, B(CH₃)₃, PH₃, and the like.

### Solar Panels

In some embodiments, the present invention is directed to a solar panel comprising at least one compositionally-graded hybrid nanowire-based photovoltaic device, wherein the solar panel isolates such devices from their surrounding atmospheric environment and permits the generation of electrical power.

### Advantages

A traditional (prior art) hybrid photovoltaic device is comprised of a semiconductor substrate of one conductivity type, and an amorphous semiconductor layer of the opposite conductivity type placed in contact with the substrate to form a heterojunction. The substrate may be n-type or p-type monocrystalline or polycrystalline semiconductor material.

In contrast to such above-described traditional hybrid PV devices, a compositionally-graded hybrid photovoltaic nanostructure-based device typically comprises a semiconductor nanowire (or nanostructure variant) film (or array) of one conductivity type on a semiconductor, metal, or glass substrate; and an amorphous semiconductor layer that is compositionally-graded across its thickness from substantially intrinsic at the interface with the substrate to substantially conductive at the opposite side. A heterojunction is formed when the amorphous semiconductor layer is compositionally-graded to the opposite conductivity type as that of the substrate. Compositional grading is achieved by adjusting the doping levels during fabrication of the amorphous semiconductor layer. The graded amorphous layering is generally disposed on the semiconductor nanowire/substrate surfaces in a conformal fashion. Note that utilization of a single compositionally-graded layer distinguishes the approach described herein from that employed by Sanyo Electric Co. (see Background), the latter of which uses a combination of distinct, individual layers to form the hybrid device, none of which are on a nanowire film active layer (i.e., using nanowires as active PV elements).

An experimental study published in J. Appl. Phys. 56(2), 15 Jul. 1984 (K.S. Lim, et al., A novel structure, high conversion efficiency p-SiC/graded p-SiC/i-Si/n-Si/ metal substrate-type amorphous silicon solar cell) investigated the effects of a graded composition a-SiC:H layer placed between the p and i layers of an a-Si/metal substrate p-i-n (positive-intrinsic-negative) thin film solar cell. Results showed enhanced V_{oc} and I_{sc} over conventional a-Si/metal substrate p-i-n devices, especially a marked increase in the collection efficiency at shorter wavelengths. The observed improvement in the blue response was attributed to a reduction in interface recombination. A computational analysis published in J. Appl. Phys. 79(9), 1 May 1996 (P. Chatterjee, A computer analysis of the effect of a wide-band-gap emitter layer on the performance of a-Si:H-based heterojunction solar cells) investigated the effects of a graded band-gap layer located between the p and i layers of a p-i-n a-Si thin film solar cell. This research indicated that using a graded band-gap layer resulted in a reduction in the number of interface states, and was found to enhance conversion efficiency in these devices by more than 25%.

As mentioned above, in some embodiments, devices of the present invention comprise a single compositionally graded semiconductor layer with intrinsic properties at one surface region and conductive properties at the opposite surface region. The graded layer is formed between a thin film comprised of semiconductor nanowires grown on a substrate that acts as the absorber, and the transparent conducting coating that serves as the electrode. This single layer simultaneously provides three important features: (1) passivation of the nanowire surface, (2) elimination of extra interfaces inherent in multilayer structures, and (3) efficient separation of charge generated in the nanowires by virtue of the close proximity of the p-n junction. Combining these two characteristics using a single layer results in a unique design to minimize carrier recombination, and thereby maximize hybrid photovoltaic device performance.

Regarding the surface passivation problem described in the background section above, in some embodiments the compositionally graded single layer is fabricated such that the substantially intrinsic region is in contact with the nanowire thin film surfaces in a conformal fashion (see above). This provides the required surface passivation and thereby reduces charge carrier recombination.

Regarding the above-described interface recombination problem (see Background), use of a single, compositionally graded layer eliminates the interface(s) between layers in a multilayer design where charge carrier recombination can occur. Interface recombination is largely due to two effects. The first is structural: abrupt band bending at a heterojunction (e.g., a p/i or n/i junction) leads to a high density of interface states that result in charge carrier recombination. Grading the dopant concentration through a single layer provides continuous variation of localized states in the energy band gap. The gradual transition of localized energy states in the band gap eliminates abrupt band bending and reduces charge carrier recombination. The second is processing: during device fabrication interruptions between processing steps allow impurity atoms and/or spurious contaminants to be trapped in the interfaces of a multilayer structure. These defects can act as sites for charge carrier recombination that degrade device performance. The continuous formation of the single graded (in terms of dopant concentration) layer removes the discontinuity in the processing sequence, thereby eliminating the interface(s) of a multilayer design and reducing charge carrier recombination.

The following examples are included to demonstrate particular embodiments of the present invention. It should be appreciated by those of skill in the art that the methods disclosed in the examples that follow merely represent exemplary embodiments of the present invention. However, those of skill in the art should, in light of the present disclosure, appreciate that many changes can be made in the specific embodiments described and still obtain a like or similar result without departing from the spirit and scope of the present invention.

### EXAMPLE 1

This Example serves to illustrate process steps for fabricating compositionally graded hybrid nanowire photovoltaic devices, in accordance with some embodiments of the present invention.

Silicon nanowire films of one conductivity type on glass, metal, or semiconductor substrate are placed in a plasma reaction chamber (e.g., a plasma enhanced chemical vapor deposition system). A vacuum pump removes atmospheric gases from the chamber. The substrates to be processed are preheated to 120 - 240°C. A hydrogen plasma surface preparation step is performed prior to the deposition of the compositionally graded layer. H₂ is introduced into the chamber at a flow rate of 50 - 500 sccm (standard cubic centimeters per minute). A throttle valve is used to maintain a constant processing pressure in the 200 - 800 mTorr range. Alternating frequency input power with a power density in the 6-50 mW/cm² range is used to ignite and maintain the plasma. Applied input power can be from 100 kHz to 2.45 GHz. Hydrogen plasma surface preparation time is 1 - 60 seconds.

At the end of the hydrogen plasma preparation step (which is optional), silane (SiH₄) is introduced into the process chamber at a flow rate of 10 - 60 sccm. This will initiate the deposition of the compositionally graded single amorphous semiconductor layer. Because no dopant precursors are included in the plasma, initially the composition of the amorphous layer is intrinsic (undoped), thus serving to passivate the surface of the semiconductor substrate. As the deposition process progresses, a dopant precursor is subsequently added to the plasma mixture. Examples of dopant precursors are: B₂H₆, B(CH₃)₃, and PH₃. These may be in pure form or diluted with a carrier gas such as argon, hydrogen or helium. The flow rate of the precursor is increased over the course of the compositionally graded layer deposition. This increasing dopant precursor flow forms a gradient in the doping concentration through the single amorphous layer (as it is deposited). At the conclusion of the graded layer deposition process, concentrations of dopant precursor in the plasma are such that substantially doped amorphous semiconductor properties are achieved.

In one embodiment, a p-type silicon nanowire film is used as the absorbing layer. After the hydrogen plasma surface preparation, the compositionally graded amorphous semiconductor single layer deposition is initiated. A mixture of pure hydrogen and silane may be used initially to form intrinsic (undoped) material properties that serve to passivate the substrate surface. Subsequently, a phosphorus-containing precursor is incrementally introduced to the plasma. Since phosphorus acts as a n-type dopant the amorphous material begins to take on n-type electrical properties. This process proceeds with increasing phosphorus-containing precursor flows until substantially conductive material properties are achieved. As a result, a compositionally graded layer comprising a phosphorus concentration that continuously varies across its thickness is obtained. The thickness of the graded layer is optimally ≤ 200 Å. In some such embodiments, this layer will form part of the front structure of the compositionally graded hybrid device. In other such embodiments, this layer will form part of the rear structure of the compositionally graded hybrid device (depending on the orientation of the device to a light source).

A transparent conductive oxide (TCO) coating is deposited on the compositionally graded layers in order to form electrodes. These coatings may be, for example, indium tin oxide (ITO) or zinc oxide (ZnO). The TCO properties, including thickness, can be selected such that these layers act as antireflective (AR) coatings. Metal contacts (e.g., Al, Ag, and the like) are formed on the top and bottom (front and rear) electrodes so as to convey the electric current generated by the device.

### EXAMPLE 2

This Example serves to illustrate an exemplary application in which photovoltaic device 100 (or variants thereof) may find use, in accordance with some embodiments of the present invention.

Photovoltaic modules containing a plurality of photovoltaic devices 100 are typically mounted onto the roofs of homes for grid-connected power generation. The modules are mounted by several methods to yield functional and aesthetic qualities. The module provides power that may be stored or sold back to the electric company for a profit, as is currently done with standard residential solar cell modules. The solar cells may be cut into standard sizes and mounted in a module frame and connected in series using standard solder-based interconnect schemes, in some cases with bypass diodes to minimize shading effects. In cases where the nanowires are grown on a transparent material, the full glass substrate may be directly used in the framed module, or the glass may be laminated and used as the module without the need for a frame. In this case, a laser scribing method typically known in the art may be used for front and backside contact to interconnect solar cell segments in series.

### Variations

While Si nanowires have been used in many of the embodiments described above, they are merely representative of a larger class of semiconductor-based elongated nanostructures. Accordingly, as will be recognized by one of skill in the art, many of the above-described embodiments can be varied to include elongated nanostructures comprising materials other than silicon. Such variant embodiments would have correspondingly different (from silicon) compositionally-graded amorphous layers.

FIGURE 4 illustrates a variation on the conformal nature of the amorphous layer depicted in FIGURE 1. In such embodiments, amorphous layer 403 substantially fills the voids between the nanotubes 101. Optionally, a layer of transparent conductive material 404 can be deposited on the amorphous layer 403, as can top and bottom electrodes (not shown).

### Summary

In summary, in some embodiments, the present invention is directed to compositionally-graded hybrid nanostructure-based photovoltaic devices comprising elongated semiconductor nanostructures and an amorphous semiconductor single layer with continuous gradation of doping concentration across its thickness from substantially intrinsic to substantially conductive. In other embodiments, the present invention is directed to methods of making such photovoltaic devices, as well as to applications which utilize such devices (e.g., solar cell modules).

Relating more specifically to some such above-described embodiments, the present invention provides for the use of a continuous, compositionally graded single semiconductor layer whose intrinsic properties near one surface region provide passivation of the semiconductor substrate reduce charge carrier recombination, and whose conductive properties near the opposite surface region provide the electrical characteristics required to form an electronic or opto-electronic device. In some such embodiments, the present invention provides for the removal of the interface between an intrinsic amorphous layer and a conductive amorphous layer where charge carrier recombination may occur. In some such embodiments, the present invention provides for removal of impurity atoms and/or spurious contaminants at the interface between an intrinsic amorphous layer and a conductive amorphous layer formed during device fabrication that result in increased charge carrier recombination. In some embodiments, the present invention provides gradation of localized energy states in the energy band gap of the compositionally graded single amorphous layer, wherein this eliminates discontinuities in localized energy states that cause charge carrier recombination at the interface(s) between layers with different band gaps and/or conductivity types. In some embodiments, the present invention provides for utilization of a one-step plasma deposition process for fabricating a compositionally-graded single layer.

It will be understood that certain of the above-described structures, functions, and operations of the above-described embodiments are not necessary to practice the present invention and are included in the description simply for completeness of an exemplary embodiment or embodiments. In addition, it will be understood that specific structures, functions, and operations set forth in the above-described referenced patents and publications can be practiced in conjunction with the present invention, but they are not essential to its practice. It is therefore to be understood that the invention may be practiced otherwise than as specifically described without actually departing from the scope of the present invention as defined by the appended claims.

## Claims

1. A photovoltaic device (100) comprising:
a) a plurality of elongated semiconducting nanostructures (101) disposed on a substrate (102), the elongated semiconducting nanostructures having a doping of a first type; and
b) an amorphous layer of semiconducting material (103) disposed conformally on the elongated semiconducting nanostructures (101) and having an interface between the amorphous layer (103) and the elongated semiconducting nanostructures (101), wherein the amorphous layer (103) is compositionally graded from substantially intrinsic at the interface to substantially conducting on the amorphous layer's opposing side, and wherein the graded composition of the amorphous layer (103) is provided by a doping of a second type.

2. The photovoltaic device (100) of claim 1, further comprising a transparent conductive material (104) disposed as a layer on the amorphous layer (103).

3. The photovoltaic device (100) of claim 1, further comprising top and bottom contacts (105) operable for connecting the device to an external circuit.

4. The photovoltaic device (100) of claim 1, further comprising a nanoporous template (102c) residing on, or integral with, the substrate (102), and from which the elongated semiconducting nanostructures (101) emanate.

5. A method for producing a photovoltaic device (100)comprising the steps of:
a) providing a plurality of elongated semiconducting nanostructures (101) on a substrate (102), the elongated semiconducting nanostructures (101) having a doping of a first type; and
b) conformally-depositing an amorphous layer (103) of semiconducting material on the elongated semicondcuting nanostructures (101) such that they form an interface, wherein the amorphous layer (103) is compositionally graded from substantially intrinsic at the interface to substantially conducting on the amorphous layer's opposing side, and wherein the graded composition of the amorphous layer (103) is provided by a doping of a second type.

6. The method of claim 5, further comprising depositing conductive transparent material (104) on the amorphous layer (103).

7. The method of claim 6, further comprising establishing top and bottom contacts (105) operable for connecting the device to an external circuit.

8. The method of claim 5, wherein the step of conformally-depositing the amorphous layer (103) is carried out using a technique selected from the group consisting of CVD, MOCVD, PECVD, HWCVD, sputtering, and combinations thereof.

9. The method of claim 5, wherein the amorphous layer (103)is compositionally graded by doping with a dopant precursor that decomposes to a dopant species upon being deposited, and wherein the doping is provided in a graded manner during deposition by progressively increasing the dopant precursor concentration as the amorphous layer (103) is deposited.

10. A solar panel comprising at least one photovoltaic device (100) of claim 1, wherein the solar panel isolates such devices from their surrounding atmospheric environment and permits the generation of electrical power.
